(19) Europäisches Patentamt
European Patent Office
Office européen des brevets

(11) **EP 0 905 777 B1**

(12) **EUROPÄISCHE PATENTSCHRIFT**

(45) Veröffentlichungstag und Bekanntmachung des Hinweises auf die Patenterteilung:
**07.05.2008 Patentblatt 2008/19**

(51) Int Cl.:
*H01L 23/525* *(2006.01)*

(21) Anmeldenummer: **98110693.3**

(22) Anmeldetag: **10.06.1998**

(54) **Verfahren zur linearen Anordnung metallischer Sicherungsstrecken auf Wafern**

Method for the linear arrangement of metallic fuse sections on wafers

Méthode d'arrangement linéaire de fusibles metalliques sur un substrat

(84) Benannte Vertragsstaaten:
**DE FR GB IE IT**

(30) Priorität: **30.09.1997 DE 19743271**

(43) Veröffentlichungstag der Anmeldung:
**31.03.1999 Patentblatt 1999/13**

(73) Patentinhaber: **Infineon Technologies AG**
**81669 München (DE)**

(72) Erfinder: **Klette, Rüdiger, Dr.**
**70806 Kornwestheim (DE)**

(74) Vertreter: **Müller - Hoffmann & Partner**
**Patentanwälte**
**P.O. Box 80 12 20**
**81612 München (DE)**

(56) Entgegenhaltungen:
**EP-A- 0 327 078**    **DE-A- 19 548 984**
**US-A- 4 536 949**    **US-A- 4 703 389**
**US-A- 4 894 791**

**Beschreibung**

Die Erfindung betrifft ein Verfahren nach dem Oberbegriff des Anspruchs 1.

Die Einstellung von Schaltungs-Kenngrößen, wie z. B. Wartezeiten und Oszillatorfrequenzen, erfolgt auf fertigen Wafern unter anderem durch das Schießen von Sicherungen. Metallische Sicherungsstrecken, die beim Schießen durchtrennt werden, sind dabei zunächst unter einer Passivierungsschicht aus Polyimid vergraben, die durch Belichtung und anschließendes Ätzen oberhalb der Sicherungen entfernt wird. Erst nach Entfernung der Polyimidschicht ist ein Schießen einer darunter liegenden Sicherung möglich. Unter optimalen Prozeßbedingungen erfolgt eine wunschgemäße Strukturierung der Polyimidschicht, so daß alle Sicherungsstrecken getrennt werden können. Unter ungünstigen Bedingungen kann es jedoch dazu kommen, daß die Polyimidschicht nicht im gesamten gewünschten Bereich entfernt wird. Nunmehr weiter unter Polyimid vergrabene Sicherungsstrecken können nicht geschossen, d. h. durchtrennt, werden. Nachdem aus dem Zustand einer Sicherungsstrecke, d. h., ob sie durchtrennt ist oder nicht, der Status eines Bits hervorgeht und die Bits in ihrer Kombination die Kenngröße bilden, kann es zu Abweichungen des der Schaltung durch Schießen von Sicherungen mitgeteilten Wertes vom Sollwert, also der Kenngröße, kommen. Hierbei ist die relative Abweichung von der Kenngröße zum einen von der Anzahl betroffener Sicherungsstrecken, die fehlerhafterweise nicht durchtrennt werden konnten, und zum anderen von der Signifikanz der Bits, die diesen Sicherungsstrecken zugeordnet sind, abhängig. Unter Signifikanz eines Bits soll in diesem Zusammenhang die Zahl verstanden werden, die, falls das Bit "1" ist, im Rahmen der Bitkombination zur zu bildenden Zahl beiträgt. Dies soll am

Beispiel der Bildung der Zahl 21 durch Bitkombination im binären Zahlensystem verdeutlicht werden.

Es gilt: $\text{Zahl} = \sum_{i=1}^{n} \text{Bit}_i \cdot 2^{i-1}$

Die Signifikanz von $\text{Bit}_i$ ist also $2^{i-1}$

Für die Zahl 21 bedeutet dies:

$$21 = \text{Bist}_1 \cdot 2^0 + \text{Bit}_2 \cdot 2^1 + \text{Bit}_3 \cdot 2^2 + \text{Bit}_4 \cdot 2^3 + \text{Bit}_5 \cdot 2^4 = 1 \cdot 2^0 + 0 \cdot 2^1 + 1 \cdot 2^2 + 0 \cdot 2^3 + 1 \cdot 2^4$$

Somit ist z. B. die Signifikanz von $\text{Bit}_5$ $2^4 = 16$. Bei Bildung der Zahl 21 durch Bitkombination ist $\text{Bit}_5$ als Bit höchster Signifikanz und $\text{Bit}_1$ als das Bit geringster Signifikanz zu verstehen.

Der Erfindung liegt die Aufgabe zugrunde, ein Verfahren zur linearen Anordnung metallischer Sicherungsstrecken, die in ihrer Bitkombination eine Kenngröße einer Schaltung auf einem Wafer repräsentieren, anzugeben, so daß auch bei ungenügender Einhaltung der Prozeßparameter und unzureichender Entfernung von Polyimid auf den metallischen Sicherungsstrecken der daraus resultierende relative Fehler der Kenngröße der Schaltung minimiert wird.

Diese Aufgabe wird gemäß dem kennzeichnenden Teil des Anspruchs 1 dadurch gelöst, daß sich die dem Bit geringster Signifikanz entsprechende Sicherungsstrecke an einem Ende der linearen Anordnung befindet, die dem Bit höchster Signifikanz entsprechende Sicherungsstrecke beidseitig von anderen Sicherungsstrecken benachbart ist.

Die dem Bit höchster Signifikanz entsprechende Sicherungsstrecke befindet sich also nicht an einem Ende der linearen Anordnung metallischer Sicherungsstrecken. Wie Untersuchungen gezeigt haben, kommt es aber bei einer ungenügenden Einhaltung der Prozeßparameter gerade an den Enden länglicher Bereiche, deren Oberflächen von Polyimidstrukturen befreit werden sollen, zu einer oft ungenügenden Entfernung des Polyimids, z. B. durch Verrundungen. Bei einer erfindungsgemäßen Anordnung der metallischen Sicherungsstrecken wird, falls die Prozeßparameter nicht korrekt eingehalten werden und es zu einer ungenügenden Polyimidentfernung kommt, zunächst die Sicherungsstrecke, welche dem Bit höchster Signifikanz entspricht hiervon nicht betroffen. Eine Beeinträchtigung der Sicherungsstrecke, die dem Bit höchster Signifikanz entspricht, wird erst bei großen Abweichungen von den vorgegebenen Prozeßparametern erfolgen. Somit können die Auswirkungen einer ungenügenden Einhaltung von Prozeßparametern auf überraschend einfache Weise minimiert werden und wo bei einer herkömmlichen Verfahrensweise Bauteile nur mehr dem Ausschuß zugeführt werden konnten, fallen nun Bauteile an, bei denen Schaltungskenngrößen minimal vom Sollwert abweichen. Diese Bauteile lassen sich zum einen in vielen Fällen noch vermarkten, zum anderen kann in nachfolgenden Qualitätskontrollen aufgrund der charakteristischen Kenngrößenabweichungen auf eine unzureichende Polyimidentfernung geschlossen werden.

Eine besonders vorteilhafte Ausführungsform der Erfindung besteht darin, daß sich die dem Bit höchster Signifikanz entsprechende metallische Sicherungsstrecke im wesentlichen in der Mitte der linearen Anordnung der metallischen Sicherungsstrecken befindet. Nachdem sich die metallische Sicherungsstrecke, welche dem Bit höchster Signifikanz entspricht und somit im größten Umfang zur Bildung der Kenngröße beiträgt, im wesentlichen in der Mitte der linearen Anordnung befindet, ist sie weitestmöglich von den Enden des länglichen Bereichs entfernt, der von dem auf dem Wafer aufgebrachten Polyimid befreit wird. Da in bezug auf die Fotolitografie insbesondere die Eckzonen von Strukturen, welche von Polyimid befreit werden sollen, von Abweichungen von den vorgegebenen Prozeßparametern und den daraus resultierenden geringeren Polyimidabtragungen betroffen sind, muß die Mitte eines länglichen Bereichs, als besonders sicher für die vollständige Polyimidentfernung gelten. Somit ist durch diese Anordnung eine Beeinträchtigung des Bits höchster Signifikanz der Kenngröße aufgrund von Fehlern bei der Polyimidstrukturierung besonders unwahrscheinlich.

Eine andere vorteilhafte Ausführungsform der Erfindung besteht darin, daß sich die dem Bit geringster Signifikanz entsprechende Sicherungsstrecke an einem Ende der linearen Anordnung befindet. Also wird bei einer ungenügenden Polyimidentfernung zunächst die Sicherungsstrecke, welche dem Bit geringster Signifikanz entspricht, oder die sich am anderen Ende der linearen Anordnung von Sicherungsstrecken befindliche Sicherungsstrecke hiervon betroffen, was im ersteren Falle die relative Abweichung vom Sollwert minimiert.

Eine weitere vorteilhafte Ausführungsform der Erfindung besteht darin, daß von der metallischen Sicherungsstrecke ausgehend, die das Bit höchster Signifikanz repräsentiert, in Richtung der beiden Enden der linearen Anordnung metallischer Sicherungsstrecken die Signifikanz der den metallischen Sicherungsstrecken zugeordneten Bits absinkt. Hierdurch ist gewährleistet, daß, sollte es zu einer sich von den Eckzonen ausgehenden ungenügenden Polyimidentfernung größerem Ausmaßes kommen, hiervon die Bits der Bitkombination betroffen sind, die aufgrund ihrer geringen Signifikanz in geringerem Ausmaß zur zu bildenden Kenngröße beitragen.

Die Erfindung wird nachfolgend anhand eines Beispiels unter Bezugnahme auf die Zeichnung näher erläutert; in dieser zeigen:

Fig. 1    ein Blockschaltbild zum Einsatz einer Sicherung bei der Voreinstellung eines Zählers,

Fig. 2    eine schematische Ansicht der Oberfläche eines Wafers, bei dem das Polyimid oberhalb einer herkömmlichen Anordnung von Sicherungen fehlerfrei entfernt wurde, und bereits Sicherungen geschossen wurden,

Fig. 3    eine schematische Ansicht der Oberfläche eines Wafers, bei dem das Polyimid oberhalb einer herkömmlichen Anordnung von Sicherungen nicht fehlerfrei entfernt wurde und bereits Sicherungen geschossen wurden,

Fig. 4    eine schematische Ansicht der Oberfläche eines Wafers wie in Fig. 3, wobei die Sicherungen jedoch erfindungsgemäß angeordnet sind.

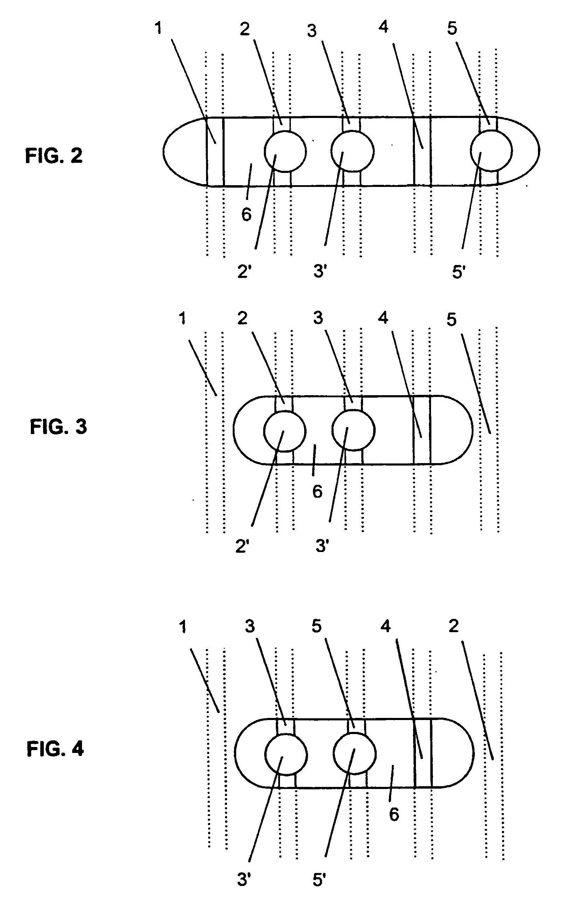

In den Fig. 2-4 sind die Sicherungen mit i = 1, 2, 3, 4, 5 als Bezugszeichen versehen. Die zugeordnete Signifikanz ist jeweils $2^{i-1}$.

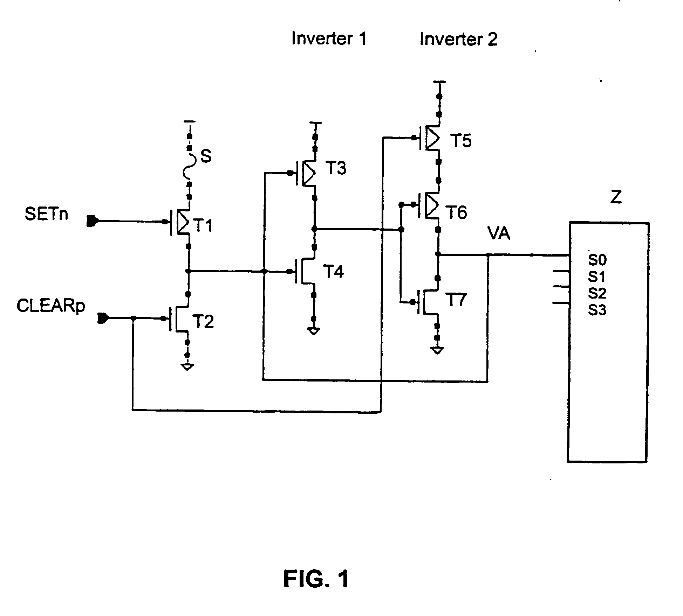

In Figur 1 ist der schaltungstechnische Einsatz einer Sicherung anhand des Beispiels der Voreinstellung eines Zählers dargestellt. Der Zähler wird beispielsweise zur Trimmung eines Oszillators, der auf einem Speicherchip die interne Rate des Speicherzellen-Refresh bestimmt, verwendet. Im Ruhezustand befindet sich die Sicherungs-Beschaltung, die aus einer Eingangsstufe T1, T2 und zwei über eine Rückkopplung verbundenen Invertern 1 und 2 besteht, im folgenden Zustand: T3, T5, T7 leiten, alle übrigen Transistoren sind gesperrt. Das Ausgangssignal, das den Zähler voreinstellt, ist auf logisch "0" gelegt. Durch Anlegen eines negativ aktiven Setzimpulses SETn wird T1 leitend. Somit wird bei nichtgeschossener Sicherung T4 geöffnet. Gleichzeitig schließt T3. Als Folge wird in der Inverterstufe 2 T6 geöffnet, T7 geschlossen und somit an VA logisch "1" erzeugt, womit der Eingang SO des Zählers auf "1" voreingestellt werden kann. Bei unterbrochener, also geschossener Sicherung wird an VA und damit der Zählereingang so auf "0" voreingestellt, da sich das Ausgangspotential gegenüber dem Ruhezustand nicht ändert. Der Schaltungszustand der beiden Inverterstufen wird durch Rücksetzen des Signales SETn aufgrund der Rückkopplung der beiden Inverterstufen nicht beeinflußt. Durch Anlegen eines CLEARp-Impulses kann die Schaltung jederzeit in den Ruhezustand zurückversetzt werden. Über die entsprechende Verwendung mehrerer Sicherungen können somit sämtliche Eingänge SO, S1, S2, S3... eines Zählers voreingestellt werden. Falls eine Sicherung nicht vollständig geschossen wurde, ergibt sich daraus eine fehlerhafte Einstellung des Zählers, die sich um so gravierender auswirkt, je höher die Signifikanz des zugeordneten Bits ist.

Fig. 2 zeigt den Bereich eines Wafers, innerhalb dessen ein länglicher Bereich 6 von dem auf der Oberfläche befindlichen Polyimidmaterial befreit wurde. Sicherungen 2', 3', 5' wurden nur in die Sicherungsstrecken 2, 3, 5 geschossen. Die Sicherungsstrecken 1 und 4 sind weiterhin ununterbrochen und somit leitend. Bereiche von Sicherungsstrecken, die unter Polyimid vergraben sind, sind gestrichelt dargestellt.

Fig. 3 zeigt die gleiche Anordnung, jedoch kam es hier in den Ecken im Bereich der Sicherungen 1 und 5 zu einer ungenügenden Polyimidentfernung, wie dies z. B. aufgrund von Fotolitografieproblemen auftreten kann. Die Sicherungsstrecken 2, 3 sind weiterhin unterbrochen. Sicherungsstrecke 5 befindet sich jedoch unterhalb der Polyimidschicht und konnte somit nicht geschossen werden, d. h. Sicherungsstrecke 5 ist weiterhin leitend. Auch Sicherungsstrecke 1 befindet sich unter der Polyimidschicht. Nachdem ein Schließen der Sicherungsstrecke 1 nicht beabsichtigt war, bleibt dies in diesem Fall ohne Auswirkung auf die Errechnung der Kenngröße der Schaltung. Diese berechnet sich wie folgt:

$$KG = C \cdot \sum_{i=1}^{n} Z(i) \cdot 2^{i-1}$$

KG :    Kenngröße
C :      Konstante
i :       Laufvariable
n :      Anzahl der Sicherungen
Z(i):    Zustand der Sicherung i, wobei der Zustand ohne Schießen 1 ist, nach Schießen 0 ist.

Somit errechnet sich für den in Fig. 2 dargestellten Fall eine Kenngröße von 22C. Im in Fig. 3 dargestellten Fall errechnet sich eine Kenngröße von 6C. Dieser eklatante Unterschied ist darauf zurückzuführen, daß die Sicherungsstrecke, die dem Bit mit der höchsten Signifikanz entspricht, also die Sicherungsstrecke 5, nicht mehr unterbrochen werden konnte.

Da der Sollwert der Kenngröße 22C beträgt, der von einer Schaltung auf dem Wafer anhand des Zustands der Sicherungen berechenbare Wert jedoch 6C beträgt, errechnet sich ein relativer Fehler von 73 %.

Eine erfindungsgemäße Anordnung der Sicherungsstrecken ist in Fig. 4 dargestellt, wobei hier die unzureichende Polyimidentfernung, wie sie in Fig. 3 dargestellt ist, übernommen wurde. Auch hier ist eine Durchtrennung, also ein Schießen, der äußeren Sicherungsstrecken nicht möglich, da sie sich unter der Polyimidschicht befinden. Errechnet man nun die sich ergebende Kenngröße, so ergibt sich ein Wert von 20C. Der relative Fehler hat sich somit bereits bei diesem einfachen Beispiel mit nur fünf Sicherungsstrecken gegenüber einer herkömmlichen Anordnung, von 73 % auf nur 9 % verringert. Je größer die Kenngröße und damit auch die Anzahl der Sicherungsstrecken wird, umso vorteilhafter wird die erfindungsgemäße Anordnung gegenüber der herkömmlichen Anordnung sein, bei der die den Sicherungsstrecken zugeordnete Signifikanz vom einen Ende der Anordnung zum anderen Ende hin ansteigt.

**Patentansprüche**

1. Verfahren zur linearen Anordnung metallischer Sicherungsstrecken, die in Ihrer Bitkombination eine Kenngröße einer Schaltung auf einem Wafer repräsentieren,
**dadurch gekennzeichnet,**
**daß** die dem Bit höchster Signifikanz entsprechende Sicherungsstrecke beidseitig von anderen Sicherungsstrecken benachbart ist.

2. Verfahren nach Anspruch 1,
**dadurch gekennzeichnet,**
**daß** sich die dem Bit höchster Signifikanz entsprechende metallische Sicherungsstrecke im wesentlichen in der Mitte der linearen Anordnung der metallischen Sicherungsstrecken befindet.

3. Verfahren nach einem der vorhergehenden Ansprüche,
**dadurch gekennzeichnet,**
sich die dem Bit geringster Signifikanz entsprechende Sicherungsstrecke an einem Ende der linearen Anordnung befindet.

4. Verfahren nach einem der vorhergehenden Ansprüche,
**dadurch gekennzeichnet,**
**daß** von der metallischen Sicherungsstrecke, die das Bit höchster Signifikanz repräsentiert, in Richtung der beiden Enden der linearen Anordnung metallischer Sicherungsstrecken die Signifikanz der den metallischen Sicherungsstrecken zugeordneten Bits absinkt.

**Claims**

1. Method for the linear arrangement of metallic fuse sections which, by their bit combination, represent a characteristic of a circuit on a wafer, **characterized in that** the fuse section corresponding to the most significant bit is neighboured on both sides by other fuse sections.

2. Method according to Claim 1, **characterized in that** the metallic fuse section corresponding to the most significant bit is located essentially in the middle of the linear arrangement of the metallic fuse sections.

3. Method according to one of the preceding claims, **characterized in that** the fuse section corresponding to the least significant bit is located at one end of the linear arrangement.

4. Method according to one of the preceding claims, **characterized in that** the significance of the bits assigned to the metallic fuse sections decreases, from the metallic fuse section representing the most significant bit, in the direction of the two ends of the linear arrangement of metallic fuse sections.

**Revendications**

1. Procédé d'agencement linéaire de sections métalliques de fusible, qui représentent dans leur combinaison de bit une grandeur caractéristique d'un circuit sur une tranche,
**caractérisé en ce que** la section de fusible correspondant au bit ayant la signification la plus grande est voisine des deux côtés d'autres sections de fusible.

2. Procédé suivant la revendication 1,
**caractérisé en ce que**
la section métallique de fusible correspondant au bit de signification la plus grande se trouve sensiblement au milieu de l'agencement linéaire des sections métalliques de fusible.

3. Procédé suivant l'une des revendications précédentes,
**caractérisé en ce que**

la section de fusible correspondant au bit de signification la plus petite se trouve à une extrémité de l'agencement linéaire.

4. Procédé suivant l'une des revendications précédentes,
**caractérisé en ce que**
parmi les sections métalliques de fusible, celle qui représente le bit ayant la signification la plus grande abaisse, dans la direction des deux extrémités de l'agencement linéaire des sections métalliques de fusible, la signification des bits associés aux sections métalliques de fusible.

Inverter 1    Inverter 2

**FIG. 1**

**FIG. 2**

**FIG. 3**

**FIG. 4**